# DEMANDE DE BREVET EUROPEEN

(11) **EP 4 742 246 A1**
(43) Date de publication de la demande: **13.05.2026**
(21) Numéro de dépôt: 25213780.7
(22) Date de dépôt: 05.11.2025
(51) Int. Cl.: G11C 13/00, H10B 63/00, H10N 70/20, H10N 70/00

(54) **PUCE ELECTRONIQUE COMPRENANT UN CIRCUIT MEMOIRE**

(30) Priorité: 07.11.2024 FR 2412187
(71) Demandeur: STMicroelectronics International N.V., 1228 Plan-les-Ouates, Geneva (CH)
(72) Inventeur: REDAELLI, Andrea, 20133 Milano (IT); ANNUNZIATA, Roberto, 20900 Monza (IT)
(74) Mandataire: Cabinet Beaumont

(57) **Abrégé**

La présente description concerne une puce électronique comprenant un circuit mémoire comprenant :
un empilement d'interconnexion ;
plusieurs cellules mémoire, chacune comprenant un élément mémoire (108) au-dessus de l'empilement et un fin-FET comprenant un premier nœud et formé dans le substrat,
chaque élément comprend une première électrode, une couche (114) comprenant un matériau OTS, et une deuxième électrode (116) connectée à la couche du côté opposé à la première électrode,
dans chaque cellule, le premier nœud du transistor est connecté à l'élément par l'intermédiaire d'un via conducteur (138) traversant toute l'épaisseur de l'empilement,
le circuit mémoire comprend un circuit de commande configuré pour appliquer, entre la première et la deuxième électrode de chaque élément, une première ou une deuxième impulsion de tension de respectivement une première ou une deuxième polarité,
opposée à la première polarité, pour définir respectivement un premier ou un deuxième état logique de l'élément.

## Description

### Domaine technique

La présente description concerne de façon générale les puces électroniques et plus particulièrement les puces électroniques comprenant un circuit mémoire basé sur un matériau de commutation à seuil ovonique (OTS).

### Technique antérieure

Les puces électroniques comportent à la fois des circuits de mémoire et des circuits logiques. On s'intéresse plus particulièrement ici à des puces électroniques comprenant des circuits de mémoire, comportant des éléments mémoire disposés en matrice, chaque élément mémoire étant associé à un ou plusieurs transistors de sélection. Ce transistor est utilisé pour programmer, effacer ou lire séparément chaque élément mémoire.

Un matériau OTS passe de l'état passant "on" à l'état bloqué "off" en fonction de la valeur de la tension appliquée à la cellule électronique. L'état du commutateur à seuil ovonique change lorsqu'une tension traversant le commutateur à seuil ovonique dépasse une tension seuil. Lorsque la tension seuil est atteinte, l'état "on" est déclenché et le commutateur à seuil ovonique est dans un état sensiblement conducteur. Si le courant ou le potentiel de tension tombe en dessous de la valeur seuil, le commutateur à seuil ovonique revient à l'état "off".

Il serait souhaitable d'améliorer au moins en partie certains aspects des puces électroniques connues.

### Résumé de l'invention

Pour ce faire, un mode de réalisation prévoit une puce électronique comprenant un circuit mémoire comprenant :
- un substrat semiconducteur ;
- un empilement d'interconnexion, disposé sur le substrat semiconducteur ; et
- une pluralité de cellules mémoire, chaque cellule mémoire comprenant un élément mémoire disposé au-dessus de l'empilement d'interconnexion et un transistor de sélection à effet de champ à ailettes comprenant un premier nœud de conduction et formé dans le substrat semiconducteur,

dans lequel chaque élément mémoire comprend une première électrode, une couche intermédiaire comprenant un matériau de commutation à seuil ovonique, et une deuxième électrode connectée à la couche intermédiaire du côté opposé à la première électrode,
dans lequel, dans chaque cellule mémoire, le premier nœud de conduction du transistor de sélection est connecté à l'élément mémoire par l'intermédiaire d'un via conducteur respectif traversant toute l'épaisseur de l'empilement d'interconnexion, et dans lequel le circuit mémoire comprend en outre un circuit de commande structuré et configuré pour appliquer, entre la première électrode et la deuxième électrode de chaque élément mémoire, une première impulsion de tension d'une première polarité pour définir un premier état logique de l'élément mémoire et une deuxième impulsion de tension d'une deuxième polarité, opposée à la première polarité, pour définir un deuxième état logique de l'élément mémoire.

Selon un mode de réalisation, la couche intermédiaire est en un matériau de chalcogénure et la deuxième électrode comprend une résistance en contact électrique avec la couche intermédiaire.

Selon un mode de réalisation, les cellules mémoire sont organisées en une matrice de lignes de bits et de lignes de mots et chaque cellule mémoire est connectée à une ligne de bits respective par sa première électrode et à une ligne de mots respective par sa deuxième électrode.

Selon un mode de réalisation, chaque transistor comprend une grille qui est connectée à une ligne de mots respective, et un deuxième nœud de conduction connecté à la masse.

Selon un mode de réalisation, les cellules mémoire sont dépourvues de tout matériau à changement de phase.

Selon un mode de réalisation, le via conducteur est en un matériau métallique.

Selon un mode de réalisation, l'empilement d'interconnexion a une épaisseur comprise dans la plage allant de 100 nm à 600 nm.

Selon un mode de réalisation, l'empilement d'interconnexion comprend une pluralité de niveaux, chaque niveau comprenant une première couche isolante et une deuxième couche isolante,
la première couche isolante est en un matériau choisi dans le groupe : SiOC, SiOC poreux, SiOCH, ou SiOCH poreux, et a une épaisseur comprise dans la plage allant de 30 nm à 110 nm, et la deuxième couche isolante est en un matériau choisi dans le groupe : carbonitrure de silicium, nitrure de silicium, SiCH, SiNHC ou SiCN poreux, et a une épaisseur comprise dans la plage allant de 2 nm à 50 nm.

Selon un mode de réalisation, la puce électronique comprend :
une troisième couche isolante interposée entre l'empilement d'interconnexion et l'élément mémoire, la troisième couche isolante étant en un matériau choisi dans le groupe : carbonitrure de silicium, nitrure de silicium, SiCH, SiNHC, ou SiCN poreux et ayant une épaisseur comprise dans la plage allant de 2 nm à 50 nm ; et
une quatrième couche isolante interposée entre la troisième couche isolante et l'élément mémoire, la quatrième couche isolante étant en SiO₂ et ayant une épaisseur comprise dans la plage allant de 10 nm à 50 nm.

Selon un mode de réalisation, pour chaque élément mémoire, le via conducteur respectif est d'un seul tenant.

Selon un mode de réalisation, la puce électronique comprend :
une couche isolante supplémentaire interposée entre le substrat semiconducteur et l'empilement d'interconnexion, et, pour chaque élément mémoire, un via supplémentaire respectif traversant toute l'épaisseur de la couche isolante supplémentaire et connectant directement le transistor de sélection au via conducteur respectif.

Selon un mode de réalisation, le via conducteur est connecté directement à la deuxième électrode de l'élément mémoire.

Un autre mode de réalisation prévoit un procédé de fabrication d'une puce électronique comprenant un circuit mémoire, comprenant les étapes successives suivantes :
a) la formation de transistors de sélection à effet de champ à ailettes, comprenant un premier nœud de conduction, dans un substrat semiconducteur ;
b) la formation d'un empilement d'interconnexion, disposé sur le substrat semiconducteur ; et
c) la formation d'une pluralité d'éléments mémoire disposés au-dessus de l'empilement d'interconnexion, chaque élément mémoire comprenant une première électrode, une couche intermédiaire comprenant un matériau de commutation à seuil ovonique, et une deuxième électrode connectée à la couche intermédiaire du côté opposé à la première électrode,

le premier nœud de conduction du transistor de sélection de chaque cellule mémoire étant connecté à l'élément mémoire par un via conducteur respectif traversant toute l'épaisseur de l'empilement d'interconnexion,
le procédé comprenant en outre une étape de formation d'un circuit de commande structuré et configuré pour appliquer, entre la première électrode et la deuxième électrode de chaque élément mémoire, une première impulsion de tension d'une première polarité pour définir un premier état logique de l'élément mémoire et une deuxième impulsion de tension d'une deuxième polarité, opposée à la première polarité, pour définir un deuxième état logique de l'élément mémoire.

Selon un mode de réalisation, le via conducteur est formé entre les étapes b) et c).

Selon un mode de réalisation, l'étape de formation des vias conducteurs comprend une étape de gravure de l'empilement d'interconnexion de sorte à former des ouvertures et une étape de remplissage de ces ouvertures.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue schématique et partielle d'un exemple de puce électronique comportant plusieurs cellules mémoire du type à commutation à seuil ovonique, selon un mode de réalisation ;
la figure 1B est une autre vue schématique et partielle de la puce illustrée en figure 1A ;
la figure 2 représente une caractéristique tension-courant de la cellule mémoire des figures 1A et 1B ; et
la figure 3 représente une vue schématique simplifiée d'un circuit mémoire selon un mode de réalisation de la présente invention.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou 10° près, de préférence à 5 % ou 5° près.

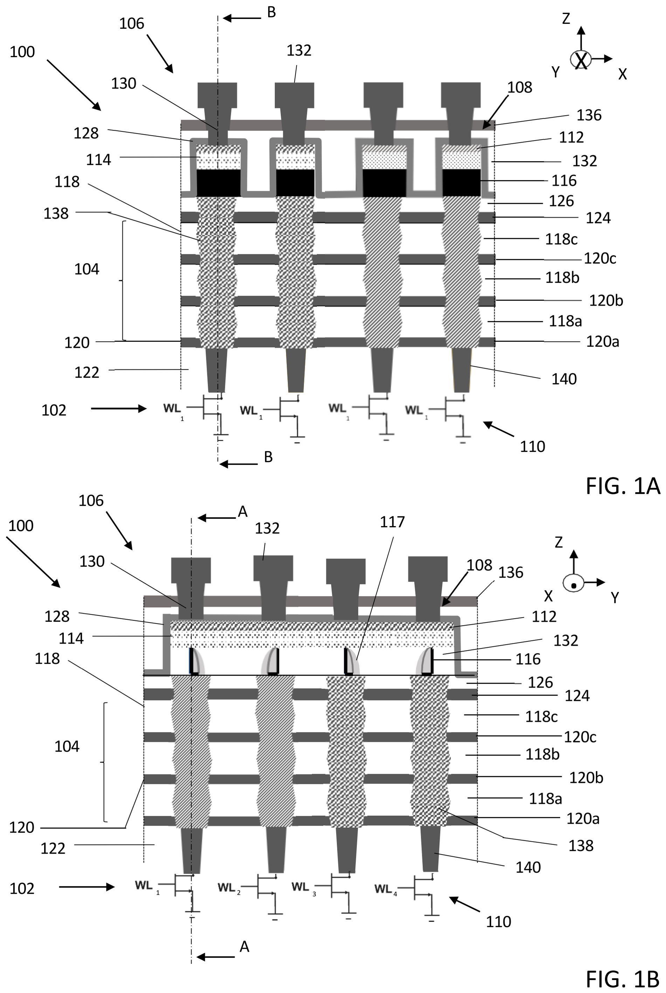

La figure 1A est une vue en coupe transversale simplifiée d'un exemple de circuit mémoire 100 selon un mode de réalisation. La figure 1B est une autre vue schématique et partielle du circuit mémoire 100 représenté en figure 1A, la figure 1A étant une vue le long du plan de coupe transversale AA de la figure 1B et la figure 1B étant une vue le long du plan de coupe transversale BB de la figure 1A.

Plus particulièrement, la figure 1A et la figure 1B illustrent une partie d'un circuit mémoire 100 d'une puce électronique 300. A titre d'exemple, la puce électronique 300 comprend, dans une partie non représentée, un circuit logique adjacent au circuit mémoire 100. Les circuits logique et mémoire sont, par exemple, fabriqués en même temps à l'intérieur et au-dessus d'un même substrat semiconducteur.

Le circuit mémoire 100 est illustré dans un système de coordonnées directes 3D XYZ, la figure 1A correspondant à une vue dans un plan XZ du système et la figure 1B correspondant à une vue dans un plan YZ du système.

Le circuit mémoire 100 comprend un substrat semiconducteur 102.

À titre d'exemple, le substrat 102 est en silicium.

Le circuit mémoire 100 comprend en outre un empilement d'interconnexion 104, disposé sur le substrat semiconducteur 102.

L'empilement d'interconnexion 104 est par exemple constitué d'une succession de niveaux, chaque niveau comprenant une première couche isolante 118 et une deuxième couche isolante 120.

L'empilement d'interconnexion 104 est par exemple formé sur une couche isolante 122. La couche isolante 122 a par exemple une épaisseur comprise dans la plage allant de 50 nm à 250 nm, par exemple dans la plage allant de 80 nm à 150 nm.

L'empilement d'interconnexion 104 est, par exemple, formé sur la surface supérieure de la couche isolante 122 et recouvre, par exemple, toute la surface de la couche isolante 122. L'empilement d'interconnexion 104 comprend, par exemple, une couche isolante 120a formée sur et en contact avec la surface supérieure de la couche isolante 122. L'empilement d'interconnexion 104 comprend en outre une couche isolante 118a formée sur la couche isolante 120a. La couche isolante 118a est par exemple formée sur toute la surface de la couche isolante 120a. A titre d'exemple, la couche isolante 118a est en contact, par sa surface inférieure, avec la surface supérieure de la couche isolante 120a. Les couches 120a et 118a forment un niveau de l'empilement d'interconnexion.

L'empilement d'interconnexion 104 peut en outre comprendre des niveaux supplémentaires formés sur et en contact avec la couche isolante 118a. Dans les figures 1A et 1B, l'empilement d'interconnexion 104 comprend deux niveaux supplémentaires, par exemple formés respectivement par des couches 118b et 120b et des couches 118c et 120c. En pratique, le nombre de niveaux de l'empilement d'interconnexion 104 peut être différent de trois, par exemple supérieur ou égal à un.

A titre d'exemple, l'épaisseur de l'empilement d'interconnexion 104 est comprise dans la plage allant de 100 nm à 600 nm, par exemple dans la plage allant de 200 nm à 500 nm, par exemple de l'ordre de 300 nm. Par exemple, l'épaisseur de chaque niveau constitué des couches isolantes 120 et 118 est comprise dans la plage allant de 80 nm à 120 nm, par exemple de l'ordre de 100 nm.

L'empilement d'interconnexion 104 est par exemple surmonté d'une couche isolante 124. La couche isolante 124 est par exemple formée sur et en contact avec l'empilement d'interconnexion 104 et plus particulièrement sur le dessus et en contact avec la couche isolante 118c. La couche isolante 124 s'étend, par exemple, sur toute la surface de l'empilement d'interconnexion 104.

A titre d'exemple, les couches isolantes 122 et 118 sont en un matériau à faible constante diélectrique, par exemple en un matériau ayant une constante diélectrique (correspondant à la permittivité dudit matériau par rapport à la permittivité du vide) inférieure à 5, par exemple inférieure à 4. Les couches isolantes 118 et 122 sont par exemple en SiOC, en SiOC poreux, en SiOCH, ou en SiOCH poreux. A titre d'exemple, les couches isolantes 120 et 124 sont en carbonitrure de silicium (SiCN), en nitrure de silicium, en SiCH, en SiNHC ou en SiCN poreux. A titre d'exemple, les couches isolantes 120 et 124 ont une épaisseur comprise dans la plage allant de 2 nm à 50 nm, par exemple dans la plage allant de 10 nm à 20 nm, par exemple de l'ordre de 15 nm. A titre d'exemple, les couches isolantes 118 ont une épaisseur comprise dans la plage allant de 30 nm à 110 nm, par exemple dans la plage allant de 50 nm à 100 nm, par exemple de l'ordre de 85 nm.

La couche isolante 124 est par exemple recouverte d'une couche isolante 126. La couche isolante 126 est par exemple en un matériau à faible constante diélectrique ou de dioxyde de silicium (SiO₂). A titre d'exemple, la couche isolante 126 est formée sur et en contact avec la surface supérieure de la couche isolante 124. A titre d'exemple, la couche isolante 126 a une épaisseur comprise dans la plage allant de 10 nm à 50 nm, par exemple dans la plage allant de 20 nm à 30 nm.

En outre, le circuit mémoire 100 comprend une pluralité de cellules mémoire 106.

Chaque cellule mémoire 106 comprend un élément mémoire 108 disposé au-dessus de l'empilement d'interconnexion 104 et un transistor de sélection à effet de champ à ailettes, ou Fin-FET 110, formé dans le substrat semiconducteur 102.

Dans cet exemple, l'empilement d'interconnexion 104 est formé entre le substrat 102 et les éléments mémoire 108. Les éléments mémoire 108 sont par exemple organisés, en vue de dessus, en une matrice de lignes et de colonnes. On parle respectivement de lignes de mots et de lignes de bits, chaque élément mémoire 108 étant situé à l'intersection d'une ligne de bits et d'une ligne de mots. À titre d'exemple, les éléments mémoire 108 illustrés en figure 1A sont des éléments mémoire 108 d'une même ligne de mots, tandis que les cellules mémoire illustrées en figure 1B sont des cellules mémoire d'une même ligne de bits. Dans la figure 1A, seules quatre lignes de bits sont représentées et, dans la figure 1B, seules quatre lignes de mots sont représentées. Toutefois, en pratique, un circuit mémoire peut comprendre un nombre de lignes de bits et de lignes de mots respectivement différent de quatre, par exemple supérieur à quatre.

Chaque élément mémoire 108 comprend une deuxième électrode, par exemple une résistance 116 ou un élément résistif ayant une valeur de résistance fixe et une première électrode 112.

La cellule électronique 100 comprend en outre une couche intermédiaire 114 comprenant, par exemple, un matériau de commutation à seuil ovonique (OTS), la résistance 116 étant connectée à la couche intermédiaire 114. La couche intermédiaire 114, ou couche OTS, est située entre la résistance 116 et la première électrode 112. La couche OTS 114 est par exemple en contact, par exemple en contact direct, avec la résistance 116.

A titre d'exemple, les figures 1A et 1B, la première électrode 112 forme une électrode de l'élément mémoire 108 tandis que la résistance 116 forme une autre électrode de l'élément mémoire 108.

Les éléments mémoire 108 sont, dans ce mode de réalisation, formés sur la surface supérieure de la couche isolante 126.

La couche OTS 114 est, par exemple, en un matériau chalcogénure, par exemple de germanium. Selon une variante, la couche OTS 114 est en tout autre matériau chalcogénure, par exemple choisi dans le groupe suivant : germanium (Ge), tellure (Te), sélénium (Se), arsenic (As) ou toute combinaison ou alliage de ces matériaux. La couche OTS peut également être dopée, de préférence avec de l'antimoine (Sb), de l'indium (In) ou du silicium (Si).

D'autres exemples de matériaux ovoniques adaptés pour former la couche OTS 114 figurent dans la demande de brevet européen N° EP09180927, déposée précédemment par le demandeur, dont le contenu est incorporé par référence dans la mesure autorisée par la loi.

Généralement, le matériau chalcogénure de la couche OTS 114 n'est pas un matériau à changement de phase, c'est-à-dire que la couche OTS est en un matériau amorphe quelle que soit l'énergie appliquée. En d'autres termes, le matériau chalcogénure de la couche OTS 114 est toujours un matériau amorphe. Cela signifie que la couche intermédiaire 114 est dépourvue de tout matériau à changement de phase.

La couche OTS 114 a, par exemple, une épaisseur supérieure ou égale à 2 nm, de préférence supérieure ou égale à 5 nm, et/ou inférieure ou égale à 15 nm, de préférence inférieure ou égale à 10 nm. A titre d'exemple, la couche OTS 114 a une épaisseur de 8 nm.

La résistance 116 a, par exemple, une section transversale en forme de L, c'est-à-dire que la résistance 116 a une partie horizontale et une partie verticale. La résistance 116 est par exemple entourée d'une couche isolante, non représentée. L'épaisseur de cette couche isolante est telle que la surface supérieure de la partie verticale de la résistance 116 est coplanaire avec la surface supérieure de la couche isolante. La résistance 116 a une section transversale en forme de L, mais la forme de la résistance 116 peut facilement être adaptée à une section transversale carrée ou à toute autre forme (non représentée). A titre d'exemple, la résistance est en contact avec la couche OTS par sa partie horizontale.

A titre d'exemple, la résistance 116 est séparée de la couche OTS 114 par une couche métallique, non représentée, qui s'étend par exemple sur toute la surface de la couche OTS.

La première électrode 112 et la résistance 116 sont, par exemple, en de mêmes matériaux métalliques, par exemple du tungstène. Selon une variante, la première électrode 112 et la résistance 116 peuvent être en deux matériaux métalliques différents. Par exemple, la résistance et/ou la première électrode est/sont en un matériau métallique (réfractaire), de préférence choisi dans le groupe : carbone (C), nitrure de carbone ((CN)n), titane (Ti), nitrure de titane (TiN), nitrure de silicium de titane (TiSiN), tungstène (W), nitrure de tungstène (W₂N, WN, WN₂), nitrure de carbone et de tungstène, nitrure de silicium et de tungstène, tantale (Ta), nitrure de tantale (TaN), nitrure de silicium et de tantale, tungstène de tantale, ou toute combinaison ou alliage de ces matériaux. À titre d'exemple, les éléments mémoire 108 comprennent un espaceur 117 recouvrant la partie horizontale de chaque résistance 116. Les espaceurs 117 sont en un matériau isolant.

Dans un autre mode de réalisation (non illustré), la deuxième électrode est une couche conductrice (par exemple, métallique) recouvrant entièrement la surface inférieure de la couche OTS 114. Dans ce mode de réalisation, la deuxième électrode a sensiblement la même structure que la première électrode. En d'autres termes, la deuxième électrode est formée par la couche métallique décrite ci-dessus qui sépare la résistance 116 de la couche OTS 114, la résistance 116 étant absente. La deuxième électrode peut être en le même matériau que la première électrode 112. Par exemple, les première et deuxième électrodes peuvent être en un matériau métallique réfractaire tel que le carbone (C), le nitrure de carbone ((CN)n), le titane (Ti), le nitrure de titane (TiN), le nitrure de titane et de silicium (TiSiN), le tungstène (W), le nitrure de tungstène (W₂N, WN, WN₂), le nitrure de carbone et de tungstène, le nitrure de silicium et de tungstène, le tantale (Ta), le nitrure de tantale (TaN), le nitrure de silicium et de tantale, le tungstène de tantale, ou toute combinaison ou tout alliage de ces matériaux.

A titre d'exemple, les éléments mémoire 108 d'une même ligne de bits sont surmontés d'une première électrode 112. En d'autres termes, les premières électrodes 112 des éléments mémoire 108 d'une même ligne de bits sont interconnectées.

Chaque élément mémoire 108 est par exemple recouvert d'une couche isolante 128 protégeant la couche 114 de matériaux OTS de l'oxydation. La couche isolante 128 est en un nitrure, par exemple en nitrure de silicium. Chaque élément mémoire 108 est en outre surmonté d'un contact métallique 130 s'étendant, par exemple, sur la métallisation 112. Les contacts métalliques 130 sont par exemple en cuivre.

La couche OTS 114 et la première électrode 112 de chaque élément mémoire 108 sont séparées des couches OTS 114 et des premières électrodes 112 respectives des éléments adjacents 108, des éléments mémoire connectés à différentes lignes de mots, par une couche isolante 132. Dans un autre mode de réalisation non illustré, la séparation se produit également entre des éléments mémoire connectés à des lignes de bits différentes. En d'autres termes, la couche OTS 114 est "entièrement confinée". La couche OTS 114 et la première électrode 112 ont, par exemple, une forme parallélépipédique ayant, par exemple, pour les deux couches, la même largeur et la même longueur.

La couche isolante 132 est par exemple en un matériau à faible constante diélectrique. Selon une variante, la couche 132 est en un oxyde, par exemple en dioxyde de silicium. À titre d'exemple, la couche 132 est en un même matériau que les espaceurs 117.

Chaque contact 130 s'étend de préférence de la surface supérieure de l'élément métallique 112 à la surface supérieure de la couche 132. Ainsi, chaque contact 130 traverse la couche 128 pour atteindre l'élément métallique 112 de la cellule correspondante. La surface supérieure de chaque élément 130 est donc coplanaire avec la surface supérieure de la couche 132.

De façon similaire à ce qui a été décrit pour les électrodes 112, les contacts 130 des éléments mémoire 108 d'une même ligne de bits sont interconnectés. Les contacts 130 sont par exemple reliés les uns aux autres dans la couche 132. Selon une alternative, chaque contact 130 est relié à un ensemble de vias conducteurs et de pistes conductrices 134 situé dans un niveau d'un réseau d'interconnexion reposant sur la couche 132.

La couche 132 est par exemple surmontée d'une couche conductrice 136. La couche conductrice 136 est par exemple en nitrure de silicium ou en carbonitrure de silicium. La couche 136 et des couches non représentées sont par exemple comprises dans le réseau d'interconnexion reposant sur la couche 132.

Chaque élément mémoire 108 est connecté électriquement au transistor de sélection 110 auquel il est associé par un via conducteur 138 traversant toute l'épaisseur de l'empilement d'interconnexion 104. À titre d'exemple, le via 138 traverse toutes les couches isolantes 118 et 120 de l'empilement d'interconnexion 104.

À titre d'exemple, le via 138 est en contact, par sa surface supérieure, avec la surface inférieure de la résistance 116 de l'élément mémoire 108. Le via 138 est par exemple en contact, par sa surface inférieure, avec un autre via conducteur 140.

A titre d'exemple, pour chaque élément mémoire 108, le via 138 correspondant relie électriquement l'élément chauffant 116 de la cellule mémoire au transistor 110.

Le via conducteur 138 est par exemple en un matériau métallique. Le via conducteur 138 est par exemple en tungstène. Selon une variante, le via conducteur 138 est en cobalt ou en cuivre. Le via conducteur 138 a, par exemple, une largeur, prise dans le plan de la figure 1A et dans le plan de la figure 1B, dans la plage allant de 40 nm à 100 nm, par exemple de l'ordre de 70 nm.

Les vias conducteurs 138 sont par exemple formés en une seule étape, après la formation de l'empilement d'interconnexion 104 et après la formation des couches 124 et 126. Par conséquent, chaque via conducteur 138 est d'un seul tenant. En effet, à la fin de la formation de l'empilement d'interconnexion 104, des ouvertures sont par exemple formées dans l'empilement d'interconnexion 104. A titre d'exemple, des ouvertures émergent sur les surfaces supérieures des vias 140. Les ouvertures s'étendent par exemple sur toute la hauteur de l'empilement d'interconnexion 104. Les ouvertures sont par exemple formées par gravure, par exemple par gravure sèche. A titre d'exemple, les ouvertures sont gravées à travers un masque de gravure. A titre d'exemple, les ouvertures sont créées par une seule étape de gravure à travers tout l'empilement d'interconnexion 104. Le masque de gravure est, par exemple, déposé et structuré avant l'étape de gravure des ouvertures par photolithographie. A titre d'exemple, les ouvertures peuvent ne pas avoir des côtés parfaitement rectilignes et verticaux. En effet, les couches 118 et 120 sont de natures différentes et n'ont donc pas la même vitesse de gravure. Il peut donc être prévu que les ouvertures soient plus larges dans les couches 118. La création des ouvertures est suivie d'une étape de remplissage des ouvertures avec le matériau du via 138, par exemple une étape de remplissage unique et continue dans le temps.

Un autre via conducteur 140 (ci-après, vias conducteurs 140 pour faciliter l'explication) traverse par exemple la couche isolante 122. Le via conducteur 140 affleure, par exemple, par sa surface inférieure, la surface inférieure de la couche isolante 122 et, par sa surface supérieure, la surface supérieure de la couche isolante 122. Le via conducteur 140 est par exemple en contact, par sa surface supérieure, avec la surface inférieure du via conducteur 138. Le via conducteur 140 est par exemple en un matériau métallique, par exemple du tungstène

A titre d'exemple, chaque transistor 110 est connecté à la résistance 116 du côté opposé à la couche intermédiaire 114. Le demandeur a observé qu'il est possible de cette façon de réduire la tension de fonctionnement de l'ensemble de la cellule électronique, ce qui présente des avantages en termes de consommation d'énergie. Par ailleurs, le demandeur a observé que le transistor peut agir comme élément sélecteur, permettant ainsi à la couche OTS 114 de n'effectuer que la fonction mémoire. De cette façon, il est possible d'utiliser une couche OTS ayant une épaisseur relativement faible.

Selon une variante, le transistor 110 peut également être connecté à la première électrode 112 du côté opposé à la couche intermédiaire 114.

Par exemple, le transistor 110 est un FinFET N-MOS. Le demandeur a observé qu'un transistor FinFET N-MOS peut être facilement piloté, ce qui simplifie le fonctionnement global du circuit mémoire. Dans un autre exemple, le transistor 110 est un FinFET P-MOS. Le demandeur a observé que les transistors FinFET ont des performances élevées, de faibles dimensions et/ou une plage de fonctionnement à haute fréquence. Cela favorise l'utilisation de la cellule électronique pour des applications embarquées, par exemple pour des applications automobiles.

Comme le montrent schématiquement les figures 1A et 1B, chaque transistor 110 est connecté par sa grille à une ligne de mots (WL).

Bien que cela ne soit pas illustré dans les figures 1A et 1B, les grilles sont reliées à des contacts métalliques, formés par exemple en haut du circuit mémoire 100. Les contacts correspondent, par exemple, aux pistes conductrices du réseau d'interconnexion s'étendant sur la couche 132.

A titre d'exemple, chaque grille est reliée à un tel contact métallique par la succession de vias et de pistes conductrices (non représentées) traversant successivement la couche isolante 122, l'empilement d'interconnexion 104, la couche conductrice 124, la couche isolante 126, la couche 128, la couche isolante 132, et la couche 136. A titre d'exemple, chaque grille est surmontée d'un via conducteur traversant la couche isolante 122, de façon similaire au via 140.

A titre d'exemple, les éléments mémoire 108 d'une même ligne de mots sont connectés au même contact.

Dans cet exemple, le transistor 110 a un premier nœud de conduction, par exemple son drain, connecté à la résistance 116 et plus précisément connecté à la partie horizontale de la résistance 116. Dans cet exemple, le transistor 110 a un deuxième nœud de conduction, par exemple sa source, connecté à la masse.

La couche OTS 114 a la propriété de présenter une diminution significative de la résistivité lorsque la tension appliquée entre l'électrode 112 et la résistance 116 dépasse une tension seuil V_{TH}. Cette diminution (ou augmentation) déclenchée par la tension qui est appliquée entre le haut et le bas de la couche permet de considérer la couche comme formant un commutateur entre un état "off" et un état "on". Si la tension appliquée à la couche OTS 114 est inférieure au seuil V_{TH} de la couche OTS 114, la couche OTS 114 reste à l'état "off" ou hautement résistif. Dans un tel état, seul un courant de fuite circule dans la cellule mémoire 106. Si une tension supérieure au seuil V_{TH} est appliquée, la couche OTS 114 passe à l'état "on" et fonctionne dans un état de résistance relativement faible. Dans l'état "on", un courant circule dans la cellule mémoire 106. La tension seuil V_{TH} de la couche OTS 114 est, par exemple, comprise entre 0,5 V et 5 V.

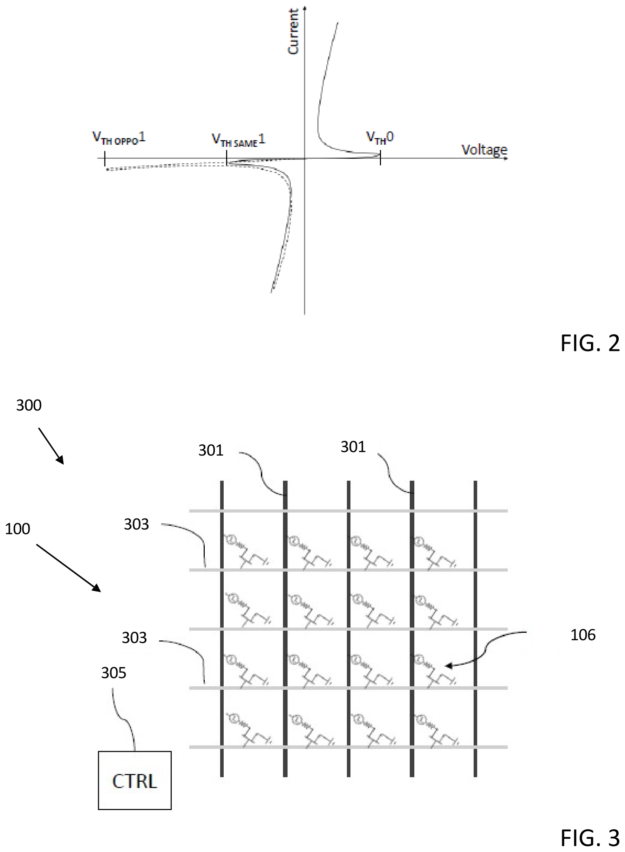

La figure 2 est un graphique illustrant l'évolution du courant en fonction de la tension appliquée aux électrodes de la cellule mémoire 106.

Dans un fonctionnement à double polarité, lorsque la tension appliquée à la cellule mémoire 106 dépasse une première tension seuil V_{TH}0 dans une polarité positive ou première polarité, la couche OTS 114 devient conductrice à l'état "on" et est programmée à "0" ou à un premier état logique, puis redevient résistive à l'état "off" à mesure que la tension appliquée diminue. De façon similaire, lorsque la tension appliquée à la cellule mémoire dépasse en valeur absolue une tension seuil V_{TH}1 dans une polarité négative ou une deuxième polarité, la couche OTS 114 devient conductrice à l'état "on" et est programmée à "1" ou à un deuxième état logique, puis elle redevient résistive à l'état "off" avec la diminution de la tension appliquée.

Les inventeurs ont constaté que, lorsqu'une cellule mémoire est programmée deux fois de suite (deux fois consécutivement) à "1", la tension seuil V_{TH}1 est moins importante en valeur absolue que lorsqu'une cellule mémoire est programmée à "0" puis à "1". En d'autres termes, si une même cellule mémoire a été programmée à "1" et est ensuite reprogrammée à "1" (sans programmation à "0" entre-temps), la tension seuil V_{TH}1 est égale à V_{TH SAME}1, tandis que si une même cellule mémoire a été programmée à "0" puis est programmée à "1", la tension seuil V_{TH}1 est égale à V_{TH OPPO}1, qui est supérieure, en valeur absolue, à V_{TH SAME}1. A titre d'exemple, la tension V_{TH SAME}1 est approximativement égale, en valeur absolue, à la tension V_{TH}0.

Pour bénéficier de cet effet mémoire, on propose de lire les cellules mémoires 106, lors d'une phase de lecture, avec une tension V_{READ} qui correspond à une tension négative dont la valeur est comprise entre V_{TH SAME}1 et V_{TH OPPO}1. Avec une telle tension de lecture, si la mesure du courant circulant dans la cellule mémoire détermine que la couche OTS 114 est conductrice, cela est dû au fait que la tension seuil V_{TH}1 correspondait au fait que V_{TH SAME}1 avait été dépassée et que la cellule mémoire avait été programmée juste avant à "1". Par contre, si la mesure du courant circulant dans la cellule mémoire détermine que la couche OTS 114 est résistive, cela signifie que la tension seuil V_{TH}1 correspondait au fait que V_{TH OPPO}1 n'a pas été dépassé et que la cellule mémoire avait été programmée juste avant à "0".

On notera que la lecture d'une cellule mémoire n'écrase pas la programmation puisque la lecture d'une programmation à "1" consiste à reprogrammer à "1" et que la lecture d'une programmation à "0" consiste à ne pas reprogrammer la cellule mémoire.

La figure 3 illustre une vue schématique simplifiée d'une puce électronique 300 comprenant un circuit mémoire 100. Le circuit mémoire 100 comprend par exemple une matrice de cellules mémoire 106. La matrice de cellules 106 comprend à titre d'exemple une pluralité de cellules mémoire 106 comme cela est illustré dans les figures 1A et 1B. Le circuit mémoire 100 comprend par ailleurs un circuit de commande 305 (CTRL), associé aux cellules mémoire, et adapté pour appliquer, sur chaque cellule mémoire, une tension entre les deux électrodes et plus précisément entre la résistance 116 et la première électrode 112.

Les cellules mémoire 106 sont, dans la figure 3, positionnées entre une pluralité de lignes de bits 301 et de lignes de mots 303. Dans la figure 3, les lignes de bits 301 sont illustrées par des lignes verticales et les lignes de mots 303 par des lignes horizontales.

A titre d'exemple, le circuit de commande 305 comprend (non représenté) pour chaque paire de lignes de bits 301 et de mots 303 un inverseur respectif (c'est-à-dire un inverseur connecté à la ligne de bits de la paire et un autre inverseur connecté à la ligne de mots de la paire). De préférence, chaque inverseur comprend un transistor p-MOS et un transistor n-MOS. De cette façon, le circuit de commande est structurellement simple et/ou présente des performances relativement élevées.

De préférence, le circuit de commande 305 est structuré et configuré pour appliquer, entre la première électrode 112 et la résistance 116, une impulsion de tension de lecture (de la première ou de la deuxième polarité) ayant une valeur de tension comprise entre le premier et le deuxième seuil de tension pour déterminer un état logique courant de la cellule électronique.

A titre d'exemple, chaque cellule mémoire 106 est connectée à une ligne de bits 301 par sa première électrode 112 et est connectée à une ligne de mots 303 par la grille de son transistor 110.

Pour être programmée, la cellule mémoire 106 doit avoir à ses bornes une tension non nulle. Pour la programmation de la cellule mémoire 106 à "0", sa ligne de bits 301 est mise à une tension correspondant à une valeur de +V et sa ligne de mots 303 est mise à une tension correspondant par exemple à une valeur de 0 V de sorte que le transistor 110 devienne passant et que la cellule électronique considérée voit une tension de V. Pour la programmation de la cellule mémoire 106 à "1", sa ligne de bits 301 est mise à une tension correspondant à une valeur de -V et sa ligne de mots 303 est mise à une tension correspondant à une valeur par exemple de 0 V de sorte que le transistor 110 devienne passant et que la cellule électronique considérée voit une tension de -V.

Pour l'un ou l'autre des programmes, les autres cellules mémoire du circuit mémoire ont soit leurs transistors 110 respectifs passants et voient une tension de par exemple 0 V, soit ils ont leur transistor 110 bloqués. Ces cellules mémoire ne sont donc pas programmées.

A titre d'exemple, la tension de fonctionnement est comprise entre 4 V et 6 V.

Dans un mode de réalisation, le circuit de commande 305 comprend, pour chaque paire de lignes de bits 301 et de lignes de mots 303, un inverseur respectif (c'est-à-dire un inverseur connecté à la ligne de bits de la paire et un autre inverseur connecté à la ligne de mots de la paire), comprenant par exemple un transistor P-MOS et un transistor N-MOS.

Un avantage du présent mode de réalisation est qu'il permet de relaxer les contraintes de dimensionnement des niveaux de métallisation pour l'intégration de cellules mémoire, dans la mesure où la surface des vias 138 peut être inférieure à la surface d'une piste connectant les lignes de mots à la surface de l'empilement d'interconnexion 104.

Un autre avantage du présent mode de réalisation est que la formation des éléments mémoire 106 au-dessus du niveau d'interconnexion 104 permet de limiter les risques de contamination de la couche OTS 114 de l'élément mémoire générés par la formation de l'empilement d'interconnexion 104 et des différents niveaux métalliques connectant les lignes de mots.

Un autre avantage du présent mode de réalisation est qu'il est compatible avec les procédés et les parties logiques connus, la partie logique n'étant pas affectée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Bien que l'on ait été décrit des modes de réalisation dans lesquels les transistors de sélection des cellules mémoires sont des transistors à effet de champ à ailettes, il peut être prévu que les transistors soient d'un autre type comme des transistors bipolaires ou des transistors MOS.

Enfin, la mise en œuvre pratique des modes de réalisation et variantes décrits est à la portée de la personne du métier à partir des indications fonctionnelles données ci-dessus.

## Revendications

1. Puce électronique (300) comprenant un circuit mémoire (100) comprenant :
- un substrat semiconducteur (102) ;
- un empilement d'interconnexion (104), disposé sur le substrat semiconducteur (102) ; et
- une pluralité de cellules mémoire (106), chaque cellule mémoire (106) comprenant un élément mémoire (108) disposé au-dessus de l'empilement d'interconnexion (104) et un transistor de sélection (110) comprenant un premier nœud de conduction et formé dans le substrat semiconducteur (102),
dans lequel chaque élément mémoire (108) comprend une première électrode (112), une couche intermédiaire (114) comprenant un matériau de commutation à seuil ovonique, et une deuxième électrode (116) connectée à la couche intermédiaire (114) du côté opposé à la première électrode (112),
dans lequel, dans chaque cellule mémoire (106), le premier nœud de conduction du transistor de sélection (110) est connecté à l'élément mémoire (108) par l'intermédiaire d'un via conducteur respectif (138) traversant toute l'épaisseur de l'empilement d'interconnexion (104),
et dans lequel le circuit mémoire (100) comprend en outre un circuit de commande (305) structuré et configuré pour appliquer, entre la première électrode (112) et la deuxième électrode (116) de chaque élément mémoire (108), une première impulsion de tension d'une première polarité pour définir un premier état logique de l'élément mémoire (108) et une deuxième impulsion de tension d'une deuxième polarité, opposée à la première polarité, pour définir un deuxième état logique de l'élément mémoire (108).

2. Puce électronique (300) selon la revendication 1, dans lequel le transistor de sélection (110) est un transistor à effet de champ à ailettes.

3. Puce électronique (300) selon la revendication 1 ou 2, dans laquelle la couche intermédiaire (114) est en un matériau chalcogénure et dans laquelle la deuxième électrode (116) comprend une résistance en contact électrique avec la couche intermédiaire (114).

4. Puce électronique (300) selon l'une quelconque des revendications 1 à 3, dans laquelle les cellules mémoire (106) sont organisées en une matrice de lignes de bits (301) et de lignes de mots (303) et dans laquelle chaque cellule mémoire (106) est connectée à une ligne de bits respective (301) par sa première électrode (112) et à une ligne de mots respective (303) par sa deuxième électrode (116) et dans laquelle chaque transistor (110) comprend une grille qui est connectée à une ligne de mots respective (305), et un deuxième nœud de conduction connecté à la masse.

5. Puce électronique (300) selon l'une quelconque des revendications 1 à 4, dans laquelle les cellules mémoire (106) sont dépourvues de tout matériau à changement de phase.

6. Puce électronique (300) selon l'une quelconque des revendications 1 à 5, dans laquelle le via conducteur (138) est en un matériau métallique.

7. Puce électronique (300) selon l'une quelconque des revendications 1 à 6, dans laquelle l'empilement d'interconnexion (104) a une épaisseur comprise dans la plage allant de 100 nm à 600 nm.

8. Puce électronique (300) selon l'une quelconque des revendications 1 à 7, dans laquelle l'empilement d'interconnexion (104) comprend une pluralité de niveaux, chaque niveau comprenant une première couche isolante (118) et une deuxième couche isolante (120),
dans laquelle la première couche isolante (118) est en un matériau choisi dans le groupe : SiOC, SiOC poreux, SiOCH, ou SiOCH poreux, et a une épaisseur comprise dans la plage allant de 30 nm à 110 nm, et dans laquelle la deuxième couche isolante (120) est en un matériau choisi dans le groupe : carbonitrure de silicium, nitrure de silicium, SiCH, SiNHC, ou SiCN poreux, et a une épaisseur comprise dans la plage allant de 2 nm à 50 nm.

9. Puce électronique (300) selon l'une quelconque des revendications 1 à 8, comprenant :
une troisième couche isolante (124) interposée entre l'empilement d'interconnexion (104) et l'élément mémoire (108), dans laquelle la troisième couche isolante (124) est en un matériau choisi dans le groupe : carbonitrure de silicium, nitrure de silicium, SiCH, SiNHC, ou SiCN poreux et a une épaisseur comprise dans la plage allant de 2 nm à 50 nm ; et
une quatrième couche isolante (126) interposée entre la troisième couche isolante (124) et l'élément mémoire (108), et dans laquelle la quatrième couche isolante (126) est en SiO₂, et a une épaisseur comprise dans la plage allant de 10 nm à 50 nm.

10. Puce électronique (300) selon l'une quelconque des revendications 1 à 9, dans laquelle, pour chaque élément mémoire (108), le via conducteur respectif (138) est d'un seul tenant.

11. Puce électronique (300) selon l'une quelconque des revendications 1 à 10, comprenant en outre :
une couche isolante supplémentaire (124) interposée entre le substrat semiconducteur (102) et l'empilement d'interconnexion (104), et
pour chaque élément mémoire (108), un autre via respectif (140) traversant toute l'épaisseur de la couche isolante supplémentaire (124) et connectant directement le transistor de sélection (110) au via conducteur respectif (138).

12. Puce électronique (300) selon l'une quelconque des revendications 1 à 11, dans laquelle le via conducteur (138) est connecté directement à la deuxième électrode (116) de l'élément mémoire (108).

13. Procédé de fabrication d'une puce électronique (300) comprenant un circuit mémoire (100), comprenant les étapes successives suivantes :
a) la formation de transistors de sélection (110), comprenant un premier nœud de conduction, dans un substrat semiconducteur (102) ;
b) la formation d'un empilement d'interconnexion (104), disposé sur le substrat semiconducteur (102) ; et
c) la formation d'une pluralité d'éléments mémoire (108) disposés au-dessus de l'empilement d'interconnexion (104), chaque élément mémoire (108) comprenant une première électrode (112), une couche intermédiaire (114) comprenant un matériau de commutation à seuil ovonique, et une deuxième électrode (116) connectée à la couche intermédiaire (114) du côté opposé par rapport à la première électrode,
le premier nœud de conduction du transistor de sélection (110) de chaque cellule mémoire (106) étant connecté à l'élément mémoire (108) par l'intermédiaire d'un via conducteur respectif (138) traversant toute l'épaisseur de l'empilement d'interconnexion (104),
le procédé comprenant en outre une étape de formation d'un circuit de commande (305) structuré et configuré pour appliquer, entre la première électrode (112) et la deuxième électrode (116) de chaque élément mémoire (108), une première impulsion de tension d'une première polarité pour définir un premier état logique de l'élément mémoire (108) et une deuxième impulsion de tension d'une deuxième polarité, opposée à la première polarité, pour définir un deuxième état logique de l'élément mémoire (108).

14. Procédé selon la revendication 13, dans lequel le via conducteur (138) est formé entre les étapes b) et c).

15. Procédé selon la revendication 14, dans lequel l'étape de formation des vias conducteurs (138) comprend une étape de gravure de l'empilement d'interconnexion (104) de sorte à former des ouvertures et une étape de remplissage desdites ouvertures.
